# EUROPEAN PATENT APPLICATION

(11) **EP 1 744 268 A2**
(43) Date of publication of application: **17.01.2007**
(21) Application number: 06253435.9
(22) Date of filing: 30.06.2006
(51) Int. Cl.: G06K 19/077

(54) **RFID tag and manufacturing method thereof**

(30) Priority: 04.07.2005 JP 2005194496
(71) Applicant: HITACHI, LTD., Chiyoda-ku Tokyo 100-8280 (JP)
(72) Inventor: Inoue, Kosue Hitachi, Ltd., Chiyoda-ku, Tokyo 100-8820 (JP); Homma, Hiroshi Hitachi, Ltd., Chiyoda-ku, Tokyo 100-8820 (JP); Odashima, Hitoshi Hitachi, Ltd., Chiyoda-ku, Tokyo 100-8820 (JP); Kanda, Naoya Hitachi, Ltd., Chiyoda-ku, Tokyo 100-8820 (JP); Ueda, Kie Hitachi, Ltd., Chiyoda-ku, Tokyo 100-8820 (JP)
(74) Representative: Calderbank, Thomas Roger

(57) **Abstract**

In an RFID (radio frequency identification) tag comprising an antenna formed of a conductive paste containing conductive filler like silver flakes on a base member, and an RFID chip connected to the antenna, the present invention cures a pattern of the antenna formed of the conductive paste, and then connects the RFID chip to the antenna with thermoplastic resin contained in the conductive paste by heating bump electrodes of the RFID chip in contact with the antenna. According to the present invention, Since the bump electrodes of the RFID chip and the antenna are connected to each other and establish sufficient electrical conduction therebetween without providing an anisotropic conductive sheet or the like therebetween, a highly reliable RFID tag is supplied at a low cost.

## Description

The present application claims priority from Japanese application JP2005-194496 filed on July 4, 2005, the content of which is hereby incorporated by reference into this application.

The present invention relates to a structure for mounting a radio frequency identification (RFID) tag in which an RFID chip having a memory storing individual identification information (ID) and an antenna are electrically connected to each other, and a method of assembling the RFID tag.

A structure ot an RFID tag and a method of assembling the RFID tag are disclosed in Patent Publication Gazette No. 3584404 (hereinafter referred to as Patent Document 1). In the disclosure, semiconductor chips are arranged with respect to an antenna formed of a metal thin film manufactured using an etching mask using a thermoplastic resin and connected as flip chips to the antenna through vibrations of supersonic waves.

Also, Patent Publication Gazette No. 2586154 (hereinafter referred to as Patent Document 2) discloses a method of connecting semiconductor chips as flip chips to a wire substrate using an anisotropic conductive sheet. According to this method, semiconductor chips for an RFID tag may be electrically connected to an antenna.

The patent documents each referred above or later are listed as follows.
[Patent Document 1] Japanese Patent Publication Gazette No. 3584404
[Patent Document 2] Japanese Patent Publication Gazette No. 2586154, and its counterpart United States Patent No. 5001542.
[Patent Document 3] Japanese Examined Patent Publication No. hei 7-60841
[Patent Document 4] Japanese Unexamined Patent Publication No. 2000-200332
[Patent Document 5] Japanese Unexamined Patent Publication No. 2002-259923

However, the related arts have problems that will be described below.

In the method disclosed in Patent Document 1, a thermoplastic resin layer of a thickness between 4 µm and 6 µm existing on the antenna is an obstacle during the connection of the flip chips through the vibrations of the supersonic waves. Thus, the vibration energy of the supersonic waves is not stably transmitted to a part in which the semiconductor chips and the antenna are to be connected to each other. As a result, a variation occurs in strength of a bonding part between bumps of the semiconductor chips and the antenna. Also, the thermoplastic resin on the antenna is not completely excluded from the bonding part between the bumps and the antenna. Thus, the thermoplastic resin remaining in the bonding part is expanded or contracted with an elapse of time. As a result, bonding between the bumps and the antenna is broken. Therefore, such a connection structure may not be used in fields requiring reliability for a long time. Also, in the corresponding connection structure, a process of removing an unnecessary part of the metal thin film using etching is required to form the antenna. Cost for forming an antenna is increased in an RFID tag having many removed parts. Thus, a selling price of an RFID tag having the corresponding connection structure is increased. As a result, in the technique disclosed Patent Document 1, flexible designs of the antenna and the RFID tag are greatly limited and thus do not sufficiently satisfy the requirements of a market of the RFID tag.

Attempts to connect semiconductor chips to an antenna based on the bonding method disclosed in Patent Document 2 have been made in many fields. However, a used anisotropic conductive sheet is manufactured based on a highly developed technique for uniformly dispersing uniform, micro conductive particles and increases manufacturing cost. Thus, it is difficult to lower a price of an RFID tag using an anisotropic conductive sheet and to mass produce RFID tags.

Also, in Patent Documents 1 and 2, semiconductor chips are connected to an antenna using a flip chip bonding method. In detail, as disclosed in Japanese Examined Patent Publication No. hei 7-60841 (Patent Document 3), a flip chip bonding apparatus having a mechanism for reversing semiconductor chips is required. However, the flip chip bonding apparatus mounts semiconductor chips one by one on an antenna with reversing the semiconductor chips. Thus, a cycle time for mounting the semiconductor chips is long, and a structure of an apparatus for manufacturing an RFID tag is complicated. As a result, the price of equipment is increased. Therefore, manufacturing cost for the whole RFID tag is increased, and thus it is difficult to supply RFID tags at a low price in volume to the market.

In Japanese Unexamined Patent Publication No. 2000-200332(Patent Document 4), a circuit pattern having a coil pattern used for an antenna is formed on a main surface of a substrate sheet formed of polyethylene terephthalate (PET) using a conductive paste. Before the conductive paste is hardened, an integrated circuit (IC) chip is mounted on the circuit pattern. Thereafter, the conductive paste is hardened to electrically connect the IC chip to the circuit pattern. Also, the circuit pattern or the IC chip is subsided in the substrate sheet in a process of covering the main surface of the substrate sheet on which the circuit pattern is formed and the IC chip is mounted with a cover sheet to complete an IC card. Thus, the circuit pattern is broken or short-circuited. Patent Document 4 discloses an improved structure in which an IC chip is mounted on a circuit pattern to solve this problem. However, the conductive paste includes a thermoplastic resin as described with reference to Patent Document 1 and remains in the circuit pattern after being hardened. Patent Document 4 overlooks a bad effect occurring on an interface between the thermoplastic resin and the IC chip due to the thermoplastic resin remaining in the circuit pattern and does not suggest the solution.

Japanese Unexamined Patent Publication No. 2002-259923 (Patent Document5) discloses an IC card in which an antenna coil is formed of a conductive paste on a main surface of a substrate formed of a resin sheet, i.e., a structure in which a bonding pad formed with an antenna coil is connected to an electrode of an IC module using a conductive adhesive. However, the conductive paste and the conductive adhesive have something in common in that conductive particles are dispersed in a resin as a binder. Thus, in the structure of Patent Document 5 in which the bonding pad is electrically connected to the electrode of the IC module by hardening the conductive adhesive, the resin of the binder may remain in the conductive paste (the bonding pad) and the conductive adhesive after being hardened. However, a bad defect caused by the resin or a solution to the bad effect is not discovered in Patent Document 5.

The present invention provides an RFID tag having a reliability of a long time manufactured at a low cost and supplied at a low price and in volume.

An RFID tag and a manufacturing method thereof according to the present invention will be described below in detail.

A conductive paste is used as a material of which an antenna of the RFID tag according to the present invention is formed. For example, the antenna is formed by printing and hardening the conductive paste on a base member. A material softened at a room temperature or more may be used as a binder material of the conductive paste. RFID chips (IC chips) are pressed against the antenna to be bonded to the antenna in an environment maintained for a predetermined period of time at a temperature equal to or more than the room temperature. Also, the antenna is formed of conductive particles dispersed in the binder through hardening of the conductive paste patterned on the antenna, and electrodes of the RFID chips are connected to the antenna to heat the antenna through the electrodes so as to electrically the RFID chips to the antenna. A thermoplastic resin is supplied to a bonding part between the RFID chips and the antenna and then hardened. A lamination covering a surface of the antenna and the RFID chips is formed of a laminate having a locally bulky thickness. Also, according to another aspect, the RFID chips may be sealed by a silicon rubber instead of the lamination.

In the manufacturing method of the RFID tag according to the present invention, the RFID chips may be reversed and then supplied to an adhesive tape to peel the RFID chips off from the adhesive tape so as to connect the RFID chips to the antenna of the RFID tag. The RFID chips adhered to the adhesive tape and connected to the antenna through electrodes are mounted on the antenna without being reversed.

Effects of the present invention will now be described. RFID chips are fixed to an antenna formed by hardening a conductive paste using softening of a binder material of the conductive paste. Thus, a material such as anisotropic conductive sheet does not need to be supplied to or supersonic energy does not need to be applied to a bonding part between the RFID chips and the antenna. An apparatus for manufacturing an RFID tag can be simplified, but a cycle time of the apparatus can be shortened. Thus, manufacturing and equipment costs for the RFID tag can be reduced.

The above and other features and advantages of the present invention will become more apparent by describing in detail exemplary embodiments thereof with reference to the attached drawings in which:
FIG. 1 is a cross-sectional view of an RFID tag according to a first embodiment of the present invention;
FIG. 2 is a cross-sectional view of a bonding part between bump electrodes 2 of RFID chips 1 and an antenna 3 of the RFID tag of the first embodiment;
FIG. 3 is a perspective view of a part of the RFID tag of the first embodiment;
FIG. 4 is a flowchart of a process of manufacturing the RFID tag of the first embodiment;
FIG. 5 is a view illustrating a mounting process performed by a flip chip mounting apparatus of the first embodiment;
FIG. 6 is a flowchart of a process of mounting RFID chips according to a second embodiment of the present invention;
FIG. 7 is a view illustrating main parts of a chip mounting apparatus using a supersonic wave peeling method and operations of the main parts;
FIG. 8 is a flowchart (1) of a process of mounting RFID chips according to a third embodiment of the present invention;
FIG. 9 is a flowchart (2) of a process of mounting RFID chips according to a third embodiment of the present invention;
FIG. 10 is a cross-sectional view of an RFID tag according to a fourth embodiment of the present invention;
FIG. 11 is a cross-sectional view of an RFID tag according to a fifth embodiment of the present invention; and
FIGS. 12(a) through 12(e) are cross-sectional views illustrating differences between structural characteristics of the RFID tag of the first embodiment of the present invention and structural characteristics of conventional IC cards.

Hereinafter, first through fifth embodiments of the present invention will be described.

### [First Embodiment]

The first embodiment of the present invention will be described in detail with reference to the attached drawings. Like reference numerals in the drawings denote like elements, and thus their description will be omitted.

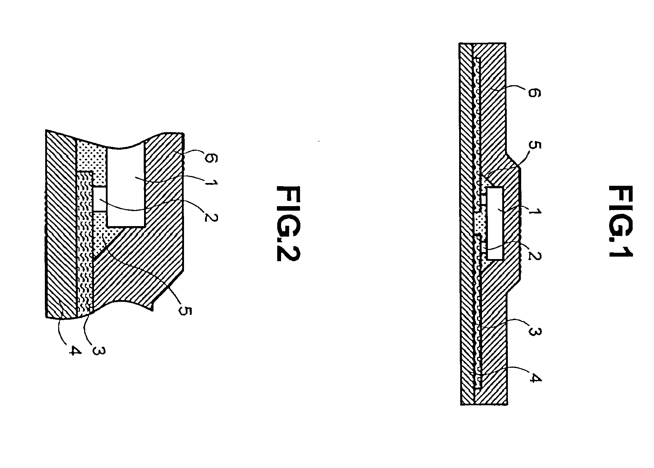

FIG. 1 is a cross-sectional view of an RFID tag according to the present embodiment. A plurality of bump electrodes 2 are formed on an RFID chip 1 and electrically connected to an antenna 3. The RFID chip 1 has a length of 0.15mm, a width of 0.15mm, and a thickness of about 20 µm, preferably, a length of 2mm, a width of 2mm, and a thickness of about 750µm. The antenna 3 is formed by patterning a conductive paste having conductive particles on a surface of a base member 4 and may be conducted in plane and thickness directions of the conductive paste. The base member 4 is formed of a resin film or paper and has a thickness between 5 µm and 500µm. An insulating resin 5 covers parts of the RFID chip 1, the antenna 3, and the member 4. A surface or superficial layer sheet 6 is bonded to cover upper surfaces of the RFID chip 1 or the antenna 3 and the base member 4.

FIG. 2 is a cross-sectional view of an enlarged bonding part among the RFID chip 1, the bump electrodes 2, and the antenna 3. The bump electrodes 2 are gold bumps formed using a plating process and have a height between 5 µ and 30 µ. The antenna 3 is formed by hardening silver particles (silver flakes) having a scale shape as conductive particles and a silver paste formed of a binder resin using a polymerization reaction or the like. The silver flakes are stacked to be overlapped with one another, and the binder resin bonds the silver particles to one another and bonds the antenna 3 to the base member 4. The bump electrodes 2 of the RFID chip 1 are also bonded to the antenna 3. Since the bump electrodes 2 are bonded to the antenna 3, the RFID chip 1 is electrically connected to the antenna 3. Also, the antenna 3 has a conductive performance of about 3x 10⁻⁵Ω·cm as a non-resistance value due to the stack structure of the silver flaks. Thus, the silver flaks may be sufficiently used as a material of which an antenna is formed. Also, in the present embodiment, the binder resin has a thermoplastic characteristic, for example, is a polyolefin-based resin, a polyester-based resin, or the like. However, a thermoplastic resin softened at a room temperature or a temperature of about 150°C may be generally used as the binder resin of the present embodiment.

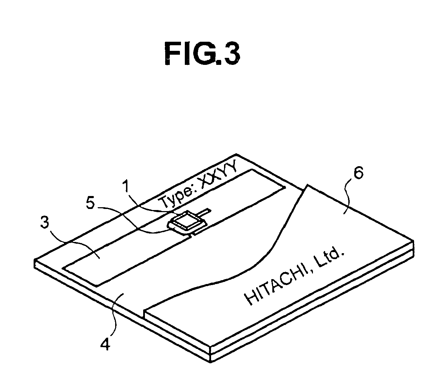

FIG. 3 is a perspective view of a part of the RFID tag according to the present embodiment. As shown in FIG. 3, characters and/or patterns for the RFID tag may be printed on the surface layer 6 and the base member 4. Alternatively, the characters and/or the patterns may be printed on a rear surface of the base member 4.

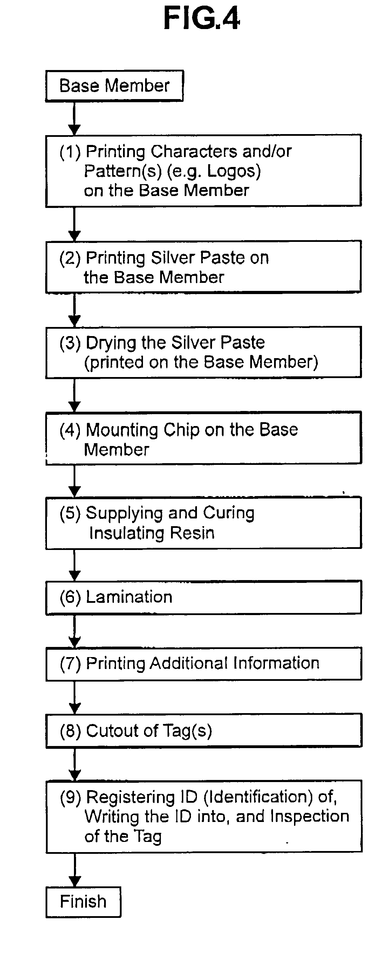

FIG. 4 is a flowchart of a process of manufacturing the RFID tag according to the present embodiment.

### (1) [Print Characters and/or Patterns]

The base member 4 wound around a roll is unwound from the roll to sequentially print characters and/or patterns, e.g., logos, on both surfaces of the base member 4. well-known offset printing or flexo printing may be used as the printing method. After the printing, an ink is dried, and then the base member 4 is re-wound around the roll.

### (2) [Print Silver Paste]

The base member 4 on which printing is completed is unwound from the roll to print a silver paste on the base member 4 so as to form a pattern of the antenna 3. Here, the silver paste may be printed using rotary screen printing, flexo printing or roll-to-roll scheme litho screen printing. A plurality of patterns of the antenna 3 may be printed within a short time using the present operation.

### (3) [Dry Silver Paste]

The base member 4 is induced into a drying furnace connected to a printer performing printing on a front page. The printed silver paste is heated in the drying furnace to volatilize a solvent component and to cure (harden) a curable (hardening) component. As a result, the patterns of the antenna 3 formed of the silver paste are sequentially formed on a surface of the base member 4. After the patterns of the antenna 3 are formed, the base member 4 is rewound around the roll. Also, the silver paste may be cured (hardened) using ultraviolet rays, an electron beam, or the like. Thus, a continuous ultraviolet ray radiation furnace is used for the silver paste cured by the ultraviolet rays or the electron beam irradiation chamber is used for the silver paste cured by the electron beam. If the silver paste is cured by the electron beam, a drying and curing time is shortened.

### (4) [Mount RFID Chip]

The base member 4 is unwound from the roll to mount the RFID chip 1 on the antenna 3 using a general flip chip mounting apparatus. The base member 4 is heated by a hot plate disposed underneath the base member 4 and the RFID chip 1 is heated by a heater of a loading collet during the mounting of the RFID chip 1. Temperatures for heating the base member 4 and the RFID chip 1 are selected from temperatures equal to or more than a room temperature at which a binder resin of the silver paste to be used is softened in the antenna 3. In general, the base member 4 and the RFID chip 1 are heated at a temperature between 50°C and 150°C. When the binder resin is softened, the RFID chip 1 is mounted so that the bump electrodes 2 contact a design position of the antenna 3. When heating the base member 4 and the RFID chip 1 stops, the temperature of the softened binder resin is lowered, and the binder resin is re-cured (re-hardened). The bump electrodes 2 are bonded and fixed to the antenna 3 using the present operation.

### (5) [Supply and Harden Insulating Resin]

An insulating resin having a paste shape is supplied around a bonding part between the bump electrodes 2 and the antenna 3. The supply of the insulating resin is performed by a dispensing apparatus connected to the flip chip mounting apparatus. The insulating resin having the paste shape is generally called ah underfill resin and has a high electricity insulating performance. The supplied insulating resin is heated and hardened by a continuously heating furnace or a batch type heating furnace connected under the dispensing apparatus.

### (6) [Perform Lamination]

A resin film or continuous paper as the surface layer 6 is laminated with respect to the surface of the base member 4. The present operation may be performed by a general laminating apparatus. An acrylic or hot melting-based adhesive may be used for laminating the surface layer 6.

### (7) [Print Additional Information]

Additional information is printed on the surface layer sheet 6 or the base member 4. The additional information may be printed using ink jet printing or laser marker printing. Thus, RFID tags are continuously formed through the first through seventh operations.

### (8) [Cut RFID Tag]

An RFID tag is cut out into individual RFID tags. The RFID tag may be cut out by punching using a mold, a rotary die cutter, or the like.

### (9) [Register, Write, and Inspect ID]

ID data of the RFID chip 1 is registered in a server, and various types of information is written to the server or the RFID chip 1. The RFID tags are inspected to be complete.

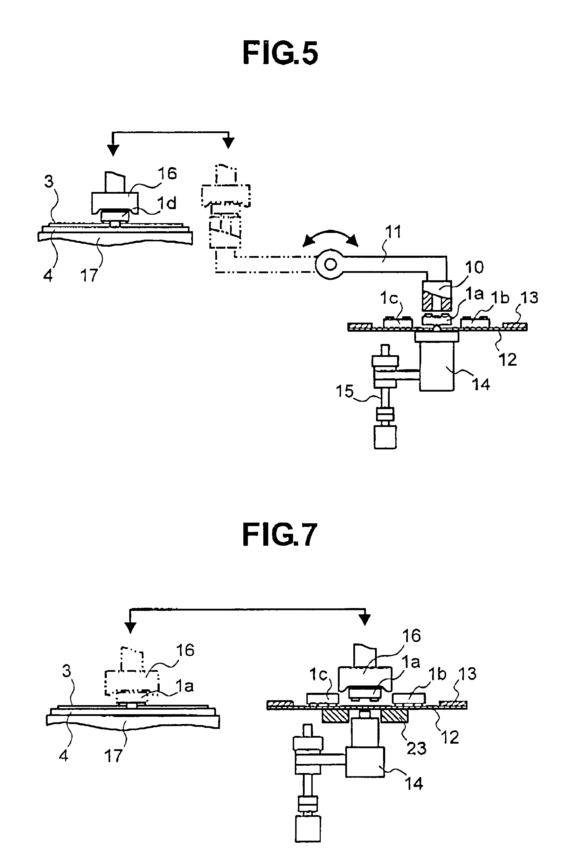

The fourth operation of FIG. 4 will now be described in detail with reference to FIG. 5. A plurality of RFID chips 1a, 1b, and 1c segmented using dicing are bonded on a dicing tape 12 (a bonding surface) bonded to a dicing frame 13. Also, the dicing frame 13 may be connected to a biaxial table (not shown), and the RFID chips 1a, 1b, and 1c and various mechanisms (a reversible collet 10 and a chip peeling mechanism 14) may be arranged in their positions. The chip peeling mechanism 14 operating using an upper and lower mechanism 15 as a driving source is disposed to be bonded to a lower surface of the dicing tape 12. A needle protrudes from an upper surface of the chip peeling mechanism 14. The needle penetrates the dicing tape 12 and raises the RFID chip 1 bonded on an upper surface of the dicing tape 12 to peel the RFID chip 1 off from the dicing tape 12.

Referring to FIG. 5, 1a denotes one of the RFID chip 1 raised by the chip peeling mechanism 14, and 1b and 1c denote the other ones of the RFID chip 1 bonded to the dicing tape 12. The RFID chip 1a peeled off from the dicing tape 12 is continuously adsorbed on the reversible collet 10 by a vacuum suction force. A reversing arm 11 to which the reversible collet 10 is attached rotates and thus moves to a position indicated by 2-dot chain lines of FIG. 5. This reversing operation reverses the RFID chip 1a adsorbed on the reversible collet 10. A mounting collet 16 approaches the RFID chip 1a in the reversed position and performs a receiving operation from the reversible collet 10 due to the vacuum suction force. The vacuum suction of the reversible collet 10 stops to open the reversible collet 10 in the air so as to transfer the RFID chip 1a from the reversible collet 10 to the mounting collet 16. The mounting collet 16 determines a mounting position of the antenna 3 and then approaches the antenna 3 to mount the RFID chip 1a on the antenna 3 (Referring to FIG. 5, an RFID chip 1d to be mounted is mounted on the antenna 3 in a cycle operation before the RFID chip 1a). Also, heat sources are stored in the mounting collet 16, the antenna 3, and a base 17 under the base member 4 on which the antenna 3 is printed. In addition, when the RFID chip 1a is mounted, temperatures of the RFID chip 1a and the antenna 3 are increased to a predetermined temperature.

A series of operations of mounting the RFID chip 1a on the antenna 3 may be repeated to mount the RFID chip 1 bonded to the dicing tape 12 on the antenna 3.

Mounting of the RFID chip 1 on the antenna is achieved through bonding between metal bumps and a plurality of silver flakes. Also, since foreign matters do not exist between the RFID chip 1 and the antenna 3, the RFID chip 1 may be more stably connected to the antenna 3.

For example, in the method disclosed in Patent Document 1, the resin layer is not excluded but intermittently exists between the bump electrodes 2 and the antenna 3. Thus, the bonding part may be broken by the expansion and contraction of the corresponding resin layer.

In the method using the anisotropic conductive sheet disclosed in Patent Document 2, bonding between the bump electrodes 2 and the antenna is achieved by the conductive particles. However, the density of the conductive particles of the anisotropic conductive sheet is set to be low to realize conductivity on in a thickness direction of the anisotropic conductive sheet. Thus, a number of conductive particles for the bonding between the bump electrodes 2 and the antenna 3 is small, and it is difficult to obtain a stable electric connection in the long run.

Compared to the above-described disclosures, in the present invention, the antenna 3 is not connected to the bump electrodes 2 only in a small amount of binder resin existing in gaps among the silver flakes. Almost whole surfaces of the bump electrodes 2 are connected to the antenna 3. According to an experiment performed on a temperature cycle between 55°C and +150°C, the method of the present invention endures a number of temperature cycles compared to methods of known techniques.

Also, the antenna 3 according to the present embodiment is formed of the stack structure of the silver flakes. Thus, if the antenna 3 is bent, the binder resin as an elastic body exists among the silver flakes. Thus, the antenna 3 may be bent with maintaining a connection state among the silver flakes. As a result, a fatigue destruction of an antenna caused by repeatedly bending of the antenna formed of a metal thin film is not observed. Also, durability of an RFID tag is considerably improved due to the bending.

As described above, according to the present embodiment, a highly reliable RFID tag may be manufactured at a very low cost.

### [Comparison of Element Structure of First Embodiment and the Prior Art]

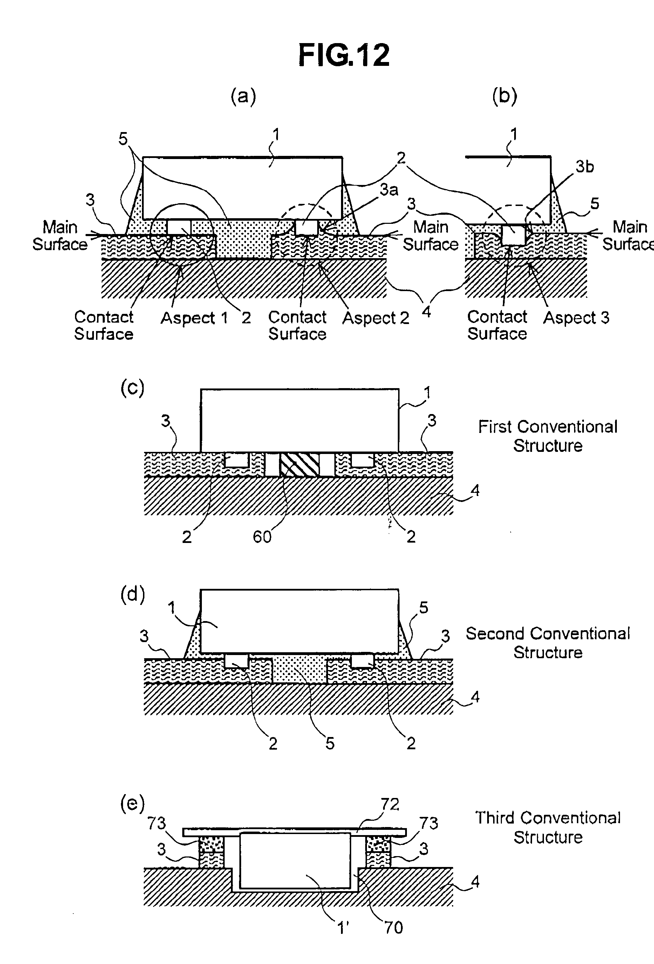

The characteristics and advantages of the element structure of the RFID tag according to the present embodiment will be described through a comparison with the element structures of the IC cards disclosed in Patent Document 4 or Patent Document 5 with reference to FIG. 12.

Two types of element structures disclosed in Patent Document 4 are shown in FIGS. 12(c) and 12(d). Referring to FIGS. 12(c) and 12(d), reference numeral 1 denotes an IC chip (corresponding to the RFID chip of the present embodiment), reference numeral 2 denotes electrode parts (corresponding to the bump electrodes of the present embodiment), reference numeral 3 denotes a mounting part (corresponding to the antenna of the present embodiment) formed of a coil pattern and a conductive paste for an antenna, reference numeral 4 denotes a substrate sheet (corresponding to the base member of the present embodiment), reference numeral 5 denotes an insulating resin. Also, reference numeral 60 denotes a backup pattern formed of the coil pattern and the conductive paste for the antenna.

As described above, in the method described in Patent Document 4, subsiding in a circuit pattern of the mounting part 3 or the substrate sheet 4 of the IC chip 1 is prevented. In a first conventional structure shown in FIG. 12(c), the mounting part 3 and the backup pattern 60 serve to prevent subsiding. In a second conventional structure shown in FIG. 12(d), the mounting part 3 is formed of a conductive paste on the substrate sheet 4. The insulating resin 10 having a thermosetting property or a thermoplasticity is coated, and then the IC chip 1 is mounted on the mounting part 3. Thereafter, the conductive paste (the mounting part 3) and the insulating resin 10 are hardened. In the first and second conventional structures, the IC chip 1 is not pushed into the substrate sheet 4 softened by heat or pressure due to a process (a laminating process) of covering a main surface of the substrate sheet 4 which is formed of polyethylene terephthalate (PET) and on which the IC chip 1 is formed with a cover sheet (corresponding to the surface sheet 6 of the present embodiment) formed of PET.

The IC card 1 described in Patent Document 4 including the first and second conventional structures shown in FIGS. 12(c) and 12(d) is manufactured by hardening the conductive paste of the mounting part 3 after the IC chip 1 is mounted on the mounting part 3. Thus, the mounting part 3 is hardened when the electrode parts 2 of the IC card 1 are buried. In other words, bottoms (on which the substrate sheet 4 is mounted) and sides of the electrode parts 2 of the IC card 1 contact the hardened conductive paste (the mounting part 3).

The element structure disclosed in Patent Document 5 is shown as a third conventional structure in FIG. 12(e). Referring to FIG. 12(e), reference numeral 1' denotes an IC module (corresponding to the RFID chip of the present embodiment) sealed by a resin, reference numeral 3 denotes a bonding pad (corresponding to the antenna of the present embodiment) formed of an antenna coil and a conductive paste, and reference numeral 4 denotes a resin sheet (corresponding to the base member of the present embodiment). Also, reference numeral 72 denotes a receptive hole formed in the resin sheet 4 to receive the ID module 1', reference numeral 72 denotes electrodes drawn from the IC module 1', and reference numeral 73 denotes an adhesive having an electrical conductivity.

To form the antenna coil and the bonding pad 3 of the third conventional structure, printing is performed on a main surface of the resin sheet 4 formed of polyvinyl chloride (PVC), polyethylene terephthalate (PET) or its amorphous state (PET-G), acrylonitrile butadiene styrene copolymer (ABS), polycarbonate (PC), or polyethylene (PE) with a conductive paste or a conductive ink formed by dispersing conductive fillers such as silver flakes, silver powder, or carbon in a resin binder such as a polyester resin, an epoxy resin, a phenol-based resin, a phenoxy resin, or a polyamide-based resin. Next, the conductive paste or ink is dried. The adhesive 73 having the electrical conductivity may be a conductive adhesive formed by dispersing metal powdered fillers such as silver, copper, or nickel in a resin binder such as an epoxy resin, an acrylic resin, a phenol-based resin, or phenoxy resin, or a conductive paste or a conductive ink formed by dispersing a very small amount of conductive minute powder such as gold, silver, or nickel in a resin binder formed of an epoxy resin, an acrylic resin, or polyamide resin.

Accordingly, when an IC card adopting the third conventional structure is completed, the antenna coil and the bonding pad 3 are formed as a material layer including the conductive fillers and the resin binders. Also, the adhesive 73 is formed on the bonding pad 3, and thus the material layer becomes thicker than the antenna coil.

Differently from the first and second conventional structures, to manufacture the RFID tag of the present embodiment, the conductive paste or ink of the antenna 3 is hardened before the bump electrodes 2 (formed of a metal or an alloy) of the RFID chip 1 (the IC chip or a semiconductor chip) is connected to a part (that is to be a bonding pad) of the antenna 3 (the circuit pattern) formed of the conductive paste or ink on the main surface of the base member 4. Also, differently from the third conventional structure, to manufacture the RFID tag of the present embodiment, the conductive paste or ink of the antenna 3 is hardened, and then the bump electrodes 2 of the RFID chip 1 is connected to a part of the antenna 3 without newly coating a part of the antenna 3 with a conductive paste or ink.

In comparison with the conventional technologies, the feature of the process of manufacturing the RFID tag according to the present embodiment is summarized in the Sequence comprising: Stage (1) of forming the antenna 3 (the circuit pattern) of the conductive paste or the conductive ink on the main surface of the base member 4 using a printing method or the like; Stage (2) of curing (hardening) the conductive paste or the conductive ink shaping the antenna 3 on the main surface of the base member 4 by drying of, heating of, light-irradiation to, or electron irradiation to the conductive paste or the conductive ink to convert the conductive paste or the conductive ink into the material layer having the conductive paste or the conductive ink as a precursor thereto; and Stage (3) of connecting the bump electrodes 2 of the RFID chip 1 to a part of the antenna 3 by heating the material layer (i.e. the antenna 3) locally. This Sequence will be described in the view of a material of the conductive paste or the conductive ink below.

While the conductive paste and the conductive ink are different from each other in viscosities, materials contained in each of the conductive paste and the conductive ink are classified broadly into conductive fillers (particles and/or flakes of metal, alloy, and/or carbon), a binder resin or a precursor thereto, and a solvent. While the binder resin adheres the conductive fillers to an object coated or printed with the conductive paste or the conductive ink as well as maintains a shape of a conductive layer formed of the conductive fillers on the object, the binder resin sometime prevents the conductive fillers from being dispersed in the conductive paste or the conductive ink. The solvent dissolves the binder resin to disperse the conductive fillers in the conductive paste or the conductive ink and give a desired viscosity thereto.

If a polyester resin representative of PET is used as the binder resin of the conductive paste or ink, an ester-based solvent such as ethyl acetate, or butyl acetate, or a ketone-based solvent such as methyl ethyl ketone or methyl isobutyl ketone is used as a solvent of the binder resin. If a polyolefin resin representative of a polyethylene resin, a polypropylene resin, or a polybutylene resin is used as the binder resin of the conductive paste or ink, an ester-based solvent such as dimethyl adipate or ethyl benzoate, an ether-based solvent such as dioxane or acetophenone, an amide-based solvent such as dimethylacetamide, a lactone-based solvent such as γ-butyrolactone or N-methyl pyrrolidinone, one of various types of sulfone-based solvents such as dimethylsulfoxide, hexane, toluene, ethyl cellosolve, cyclohexanone, or benzyle alcohol is used as a solvent of the binder resin. If an acrylic resin representative of methylmethacrylate, ethylmethacrylate, or polycarbonate is used as the binder reins of the conductive paste or ink, chloroform, acetone, ethyl carbitol, or butyl cellosolve acetate is used as a solvent of the binder resin.

Also, in a certain type of conductive paste or the conductive ink, a binder resin or a precursor of the binder resin is not dissolved in a solvent, but a dispersant dispersing conductive fillers in the precursor is mixed with the precursor. However, although the dispersant does not dissolve a binder resin or a precursor of the binder resin, the dispersant is defined as a solvent in "a broad sense" in the present specification because the dispersant plays a similar role to that of the solvent in the following description. In other words, the dispersant disperses conductive fillers in a conductive paste or a conductive ink and gives a desired viscosity to the conductive paste or the conductive ink as well as a solvent in "a narrow sense" dissolving the binder resin or the precursor thereto does.

In the stage (2) of the above-described Sequence, the solvent in the broad sense is removed from the conductive paste or ink in the process of hardening the conductive paste or ink by drying, heating, irradiating with light, or irradiating with an electron beam. Also, if the conductive paste or ink includes the precursor of the binder resin, the binder resin is generated by a reaction of the precursor to reduce a content of the precursor in the conductive paste or ink. Thus, the viscosity of the conductive paste or ink of the antenna 3 is increased. The conductive paste or ink is substantially solidified as the material layer (a layer of a material using a conductive paste or a conductive ink as a precursor thereto) formed of the conductive fillers and the binder resin. Since the silver paste is solidified as described above, the base member 4 on which the pattern of the antenna 3 is formed of the silver paste is dried and then wound around the roll.

In the stage (3) of the above-described Sequence characterizing the process of manufacturing the RFID tag of the present embodiment, the part of the material layer having a volume dominantly occupied with the conductive fillers and the binder resin is heated. A behavior of the binder resin in the heated part of the material layer gives a characteristic structure to the RFID tag of the present embodiment and an effect according thereto.

First of all, in the stage (2), when the conductive paste or the conductive ink is cured (hardened), the conductive fillers precipitated toward the base member 4 in the material layer (the antenna 3) are heated to migrate in the softened binder resin, and some of the conductive fillers approach the bump electrodes 2 of the RFID chip 1. Due to the sort of migration of the conductive fillers, a distribution of the conductive fillers in the heated part of the material layer in a thickness direction thereof is shifted closer to the bump electrodes 2. In other words, as an uneven distribution of the binder resin at the side of the corresponding material layer closer to the bump electrodes 2 is relieved, the break of the bonded part between the bump electrodes 2 and the antenna 3 which is described above with reference to the Patent Document 1 and occurs in the technique disclosed in the Patent Documents 4 or 5 will be avoided.

The migration of the conductive fillers in the heated part of the material layer (the antenna 3) lowers a contact resistance between a current path formed of the conductive fillers in the other part of the material layer (not intentionally heated) and the RFID chip 1.

On the other hand, the softened binder resin indicates a wettability to the bottom surfaces of the bump electrodes 2 (surfaces facing the base member 4) and is bonded to the bottom surfaces of the bump electrodes 2. When heating the material layer in the stage (3) is ended, the softened binder resin is re-hardened with its sufficient adhesion to the bottom surfaces of the bump electrodes 2. Thus, the RFID chip 1 is satisfactorily fixed to the antenna 3 and the base member 4 through the bump electrodes 2.

If curing (hardening) of the material layer starts with maintaining its contact to the bump electrodes 2 of the RFID chip 1 before the material layer printed or coated on the main surface of the base member 4 to form the pattern of the antenna 3 is cured, the conductive fillers in the material layer are escaped from a region of the material layer contacting the bump electrodes 2. Thus, although the RFID chip 1 is fixed to the antenna 3 through the bump electrodes 2, the electrical connection failure between the RFID chip 1 and the antenna 3 may be occurred. In the present invention, an enough density of the conductive fillers to achieve the electrical connection between the RFID chip 1 and the antenna 3 is secured in the region of the material layer contacting the bump electrodes 2 due to the migration of the conductive fillers. Thus, such the electrical connection failure is prevented.

To realize the bonding configuration between the RFID chip 1 and the antenna 3 according to the present embodiment, it is preferable that the binder resin of the conductive paste or the conductive ink used for forming the antenna 3 has thermoplasticity. A glass transition temperature Tg is an index for evaluating the thermoplasticity of a resin material. When the cured (hardened) resin material (in a glass region) is heated at a temperature equal to or higher than the glass transition temperature Tg thereof, the resin material is transited to a rubber region and softened with an increase in the temperature. When the resin material is heated at a temperature higher than the glass transition temperature Tg thereof, the resin material is transited from the rubber region to a flow region. The transition of the resin material from the glass region to the rubber region may be regarded as an increase in a thermal expansion coefficient of the resin material. The transition of the resin material from the rubber region to the flow region may be regarded as a decrease (breakdown) in the thermal expansion coefficient. The relationship between the transitions and the temperature of the resin material is affected by a load on the resin material. The binder resin should preferably be in a rubber state at the temperature for heating the antenna 3 in the stage (3) to soften the binder resin of the material layer of the antenna 3 to give appropriate viscosity and elasticity to the binder resin and to bond the bump electrodes 2 of the RFID chip 1 to the binder resin. If the binder resin is transited to the flow region, the pattern of the antenna 3 obtained in the stage (2) cannot be maintained. On the other hand, in the stage (3), the antenna 3 is heated so as not to damage the base member 4 and the RFID chip 1. Thus, it is preferable that the binder resin is appropriately softened at the limited heating temperature and transited to a glass state within an ambient temperature range of using the RFID tag.

From this point of view, various types of saturated polyester resins or saturated copolymer polyester resins (Tg=80°C-90°C) obtained through the known condensation polymerization using "an acid component" such as terephthalic acid, isophthalic acid, diphenyl carboxylic acid, adipic acid, or sebacic acid and "an alcohol component" such as ethylene glycol, 1,4-butanediol, 1,4-dicyclohexanedimethyol, or dialcohol such as diethylene glycol as raw materials are available for the binder resin preferably. Also, polyethylene terephthalate (PET, Tg=76 - 105°C) belonging to a polyester resin is also available for the binder resin. A polyethylene resin known as a polyolefin resin is classified in accordance with molecular weight or polymerization pattern thereof into various resins from one of them showing a very low glass transition temperature (Tg=-120°C) to the other of them used for a porous resin reflection sheet and having a relatively high glass transition temperature (Tg=140°C or more). Also, a homopolymer formed of norbornene polycyclic olefin, a copolymer formed of norbornene polycyclic olefin and noncyclic α-olefin, a homopolymer formed of tetracyclododecene polycyclic olefin, and a copolymer formed of tetracyclododecene polycyclic olefin and noncyclic α-olefin are "polyolefin resins (cyclic polyolefin resins) having a glass transition temperature between 50°C and 80°C." Amorphous plastic of a methacrylic acid ester polymer is "an acrylic resin starting to be softened at a temperature between 80°C and 100°C." The binder resin, and a binder resin to be included. The binder resin to be contained in the conductive paste or the conductive ink used for forming the antenna 3 needs not to be limited to the above-exemplified resins but may be selected in accordance with a temperature for heating the antenna 3 in the stage (3). A guide to select a binder resin is that a glass transition temperature of the binder resin is within a range between 50°C and 150°C.

The behavior (migration) of the binder resin with respect to heat applied thereto is reflected on the pattern (shape) of the antenna 3 (the material layer forming the antenna) to which the bump electrodes of the RFID chip 1 are connected while heated. In FIGS. 12(a) and 12(b) each enlarging a part of the RFID tag of the present embodiment on which the RFID chip 1 of is mounted, cross-sectional shapes of the antenna 3 (the material layer) to which the bump electrodes 2 are connected are classified into Aspect 1, Aspect 2, and Aspect 3.

As shown in FIG. 5, if the RFID chip 1 is heated in the collet 16 supplying the RFID chip 1 to the base member 4, a temperature of the bump electrodes 2 formed of the metal or the alloy is increased higher than that of a main body of the RFID chip 1 (formed of a semiconductor or an insulating material). Although a whole rear surface of the base member 4 is heated by the base 17, the temperature of the bump electrodes 2 rises faster than other elements, i.e., the base member 4, the antenna 3, and the RFID chip 1. In the present specification, each portion of a surface of the antenna 3 in contact with bottom surfaces of the bump electrodes 2 facing the base member 4 will be defined as "a contact surface," hereinafter. When the binder resin of the material layer constituting the antenna 3 is softened in "a contact surface" thereof in contact with the heated bump electrodes 2 (facing the base member 4) and "a limited region around the contact surface" in a surface thereof, the antenna 3 is connected to the bump electrodes 2 of the RFID chip 1 as shown in the Aspect (1). In the Aspect (1), the bump electrodes 2 of the RFID chip 1 is bonded to the main surface of the antenna 3 (its upper surface in relation to the base member 4) without denting the main surface of the antenna 3 cured in the aforementioned Stage (2). Differently from the first or second conventional structure, the sides adjacent to the bottoms of the bump electrodes 2 do not contact the material of which the antenna 3 is formed. Also, differently from the third conventional structure, the part of the antenna 3 contacting the bump electrodes 2 of the RFID chip 1 is not thicker than other parts of the antenna 3 (parts operating as antennas).

If the binder resin of the material layer of the antenna 3 is softened in a relatively wide range (in the main surface of the antenna 3) from "the contact surface" of the antenna 3 contacting the bottom surfaces of the heated bump electrodes 2, the contact surface shows the Aspects (2) or (3). In the Aspect (2), the binder resin of the antenna 3 (the material layer) heated by the bump electrodes 2 is so expanded that the binder resin creeps up on side surfaces of the bump electrodes 2 adjacent to the bottom surfaces thereof toward (a bottom surface of) the RFID chip 1. At least portions of the side surfaces of the bump electrodes 2 are covered with a material 3a of the antenna 3 (protruded upward in relation of the main surface of the antenna 3), but the bottoms of the bump electrodes 2 are precipitated from the main surface of the antenna 3 hardened in the Stage (2) toward the base member 4. This is because the material layer of the antenna 3 underneath the bottom surfaces of the bump electrodes 2 also expands. Differences between the Aspect (2) and the first and second conventional structures may be clearly recognized by comparing the contact surface of the antenna 3 contacting the bottom surfaces of the bump electrodes 2 with main surfaces of the other parts of the antenna 3 (for example, the parts operating as antennas) spaced apart from the RFID chip 1. Also, the Aspect (2) is different from the third conventional structure in terms of a protrusion 3a of the material of the antenna 3 toward the sides of the bump electrodes 2.

The Aspect (3) may be observed when a force for pressing the RFID chip 1 against the antenna 3 through the collet 16 is great or the expansion of the binder resin of the material of the antenna 3 is small. Also, the contact surface of the antenna 3 contacting the bottoms of the bump electrodes 2 and parts around the contact surface are dented by the thermoplasticity of the binder resin. The bottoms of the bump electrodes 2 are subsided from the main surface of the antenna 3 hardened in the Stage (2) toward the base member 4. However, as shown in FIG. 12(b), a part enclosing the contact surface of the antenna 3 forms a slanting surface 3b extending from the dented part of the contact surface to the main surface of the antenna 3 during hardening. Thus, the sides contacting the bottoms of the bump electrodes 2 comes apart from the material layer of the antenna 3 in the part in which the bottoms of the bump electrodes 2 are subsided from the main surface of the antenna 3 toward the base member 4. As described above, the third aspect is different from the first and second conventional structures in that the slanting surface 3b facing the sides of the bump electrodes 2 through a gap is formed around the contact surface of the antenna 3. Also, the third aspect is different from the third conventional structure in that the part of the antenna 3 contacting the bottoms of the bump electrodes 2 is thinner than the other parts of the antenna 3.

The Aspects (1)-(3) may be observed when the part of the antenna 3 contacting the bump electrodes 2 of the RFID chip 1 is heated by infrared rays from the base member 4. The first through third aspects are formed through a manufacturing process of hardening the conductive paste or ink of the antenna 3, heating the part of the antenna 3, and connecting the bump electrodes 2 of the RRID chip 1 to the part. Thus, the advantages of the manufacturing process are obtained through the connection of the bump electrodes 2 of the RFID chip 1 to the antenna 3 using one of the Aspects (1) - (3). In other words, the local part of the binder resin of the antenna 3 toward the bump electrodes 2 is relieved, the bonding part between the bump electrodes 2 and the antenna 3 is prevented from being broken, and the RFID chip 1 is electrically connected to the antenna.

Also, as shown in the Aspects (2), although the material of the antenna 3 protrudes toward the sides of the bump electrodes 2, a surface tension of the material is reduced by hardening of the antenna 3 and thus does not reach a bottom (on which the bump electrodes 2 are formed) or side (adjacent to the bottom, for example, a dicing surface) of the RFID chip 1. In addition, in the Aspect (2), regions of the sides of the bump electrodes 2 adjacent to the bottom of the RFID chip 1 are not covered with the material of the antenna 3. Thus, unexpected electric short-circuit caused by the contact of the material of the antenna 3 with a conductor besides the bump electrodes 2 exposed from the bottom or side of the RFID chip 1 does not occur in the RFID tag.

After the antenna 3 is formed of the conductive paste or ink and hardened, a solvent dissolving the solvent in the broad sense, i.e., the binder resin, the dispersant dispersing the conductive filters in the conductive paste or ink, or the precursor of the binder resin may remain in a small amount in the antenna 3. In the present embodiment, the part of the antenna 3 formed by hardening the conductive paste or ink is re-heated as described above. Thus, the solvent in the broad sense remaining in the heated part or a part around the heated art is removed, and the precursor is removed or changed into the binder resin.

Thus, if the completed RFID tag of the present embodiment is disassembled to sample the material of the antenna 3 from the part of the antenna 3 covered with the RFID chip 1 and the other parts (the antenna parts extended toward an outside of the RFID chip 1) and the sampled materials are analyzed by a gas chromatography, the density (concentration) of the solvent in the broad sense or the precursor of the binder resin contained in the material sampled from the part is lower than that of the material sampled from the other parts. A small amount of solvent or precursor of the binder resin remaining in the antenna 3 does not disturb receiving and transmitting of electronic waves through the antenna parts. However, a contact pad of the antenna 3 contacting the RFID chip 1 (the bump electrodes 2) locally radiates heat due to a current passing through the contact surface and a resistance around the contact surface. The solvent in the broad sense has a light molecular weight and thus may be evaporated in the part (the contact pad) of the antenna 3 locally radiating the heat to form air bubbles among the conductive fillers. If the solvent in the broad sense remaining in a small amount in the part of the antenna is removed again, the air bubbles are prevented from being formed among the conductive fillers, and electric resistances among the conductive fillers become lower. Thus, a current induced by electronic waves received from the other parts (the antenna parts) of the antenna 3 or inducing electronic waves transmitted from the other parts passes between the part of the antenna 3 and the RFID chip 1 without loss.

The above-described characteristics of the RFID tag of the present invention will now be grasped in terms of other aspects. The density (for example, wt%) of the conductive fillers of the part of the antenna 3 covered with the RFID chip 1 is higher than the density of the conductive fillers of the other parts (the antenna parts). Thus, in the Aspects (1)-(3), although a contact area between the bump electrodes 2 of the RFID chip 1 and the antenna 3 seems to be narrower than those of the first or second conventional structure, an electric resistance per the contact area is reduced lower in the present invention. Also, the antenna 3 is cured before being connected to the RFID chip 1. Thus, the conductive fillers existing in a region of the antenna 3 contacting the bump electrodes 2 to a high density do not form unexpected electrical short-circuit between the RFID chip 1 and the antenna 3. This may be clear from the description of the Aspects (2) of the present invention.

The above-described characteristics or advantages are unique points of the RFID tag of the present embodiment that are not observed in the first, second, and third prior arts of bonding an IC chip to a conductive paste, a conductive ink, or a conductive adhesive that is not hardened (in a state in which the solvent in "the broad sense" or the precursor exists in a large amount) and then hardening the conductive paste, the conductive ink, or the conductive adhesive. If the other part of the antenna 3 is heated from the RFID chip 1 through the collet 16 shown in FIG. 5, the density of the solvent in "the broad sense" or the precursor becomes lower in a part enclosed by a circle, particularly, the contact surface shown in FIG. 12(a) or 12(b) and a part around the contact surface.

The RFID tag of the present embodiment is more solidified by sealing the connection structure between the antenna 3 and the bump electrodes 2 of the RFID chip 1 by the insulating resin 5. The insulating resin 5 is a sealing material called an underfill resin, and an epoxy resin having a glass transition temperature Tg between 100°C and 138°C is known as a representative sealing material. The glass transition temperature of the epoxy resin is determined by fillers (for example, crosslinked silicon particles) dispersed in the epoxy resin or a diameter of particles of the fillers. An epoxy resin having dispersed alumina particles and a glass transition temperature of 190°C has been developed. Also, a biphenyl resin (Tg=140°C) or a polyurethane resin (Tg=170 - 190°C) has been developed as underfill resins. The insulating resin 5 may be formed of a thermoplastic resin that is not solidified by heat and pressure and then re-melted or reformed without damage to original properties to seal the connection structure of the antenna 3 formed of the conductive paste or ink with the bump electrodes 2 of the RFID chip 1 by the insulating resin 5. Also, the insulating resin 5 may be formed of a resin material having a higher transition temperature than the binder resin (not the precursor thereof) of the conductive paste or ink.

The characteristics of the RFID tag of the present embodiment bring about the effects as previously described in the Summary of the Invention. In other words, when the RFID tag of the present invention is manufactured, a material such as an anisotropic conductive sheet does not need to be supplied to or supersonic energy does not need to be applied to the bonding part between the RFID chip 1 and the antenna 3. A structure of an apparatus for manufacturing the RFID tag is simplified, and manufacturing cycle time is shortened.

The RFID tag and the manufacturing method thereof described in the present embodiment show at least one of the following effects.
(1) A conductive paste is printed on a base member to form an antenna of the RFID tag. Thus, the printing process (forming process) of the antenna may be trusted to a printer. The strongpoint of manufacturing the RFID tag is intensive. Also, an in-process inventory of the RFID tag may be reduced in the strongpoint.
(2) The antenna of the RFID tag may be formed without an etching process. Thus, equipment for the etching process, an etchant and a rinse solution for wet processes, and an etching gas for a dry process are not required. Processing unit costs may be removed from a price of the RFID tag.
(3) The antenna is formed of the conductive paste. Thus, the durability of the RFID tag is improved with respect to repeated bending caused by an uncompleted RFID tag having an antenna formed of a metal thin film.
(4) An RFID chip is fixed to the antenna by softening a binder material of the conductive paste. Thus, bump electrodes of the RFID chip are stably connected to the antenna without an interposed material therebetween. Also, a highly reliable RFID tag is realized.
(5) A part around a bonding part between the RFID chip and the antenna is covered with a thermoplastic resin. Thus, an invasion of moisture into the bonding part or an effect of a distortion caused by bending of the RFID tag is reduced. The durability of the stable bonding part between the bump electrodes of the RFID chip and the antenna described in the item (4) is further improved.
(6) The antenna is formed by highly precise printing such as screen printing or the like. Thus, RFID tags having highly precise antennas may be mass-produced. Thus, when the RFID tags communicate with a reader writer, an energy loss caused by pattern errors of the antennas among the RFID tags is reduced. As a result, RFID tags having low variations in communication distances may be realized.
(7) The antenna may be formed by the screen printing with inexpensive transfer plates easy for set-up change. Thus, the price of RFID tags is inhibited from being increased in the manufacture of a wide variety of RFID tags in small quantities.
(8) The supersonic energy does not need to be applied for the connection between the RFID chip and the antenna. Thus, a low density, thin RFID chip may be used. As a result, a thinner RFID tag may be manufactured.

The structural characteristics and effects of the RFID tag of the present embodiment as described above are shown in RFID tags according to other embodiments that will be described below.

### [Second Embodiment]

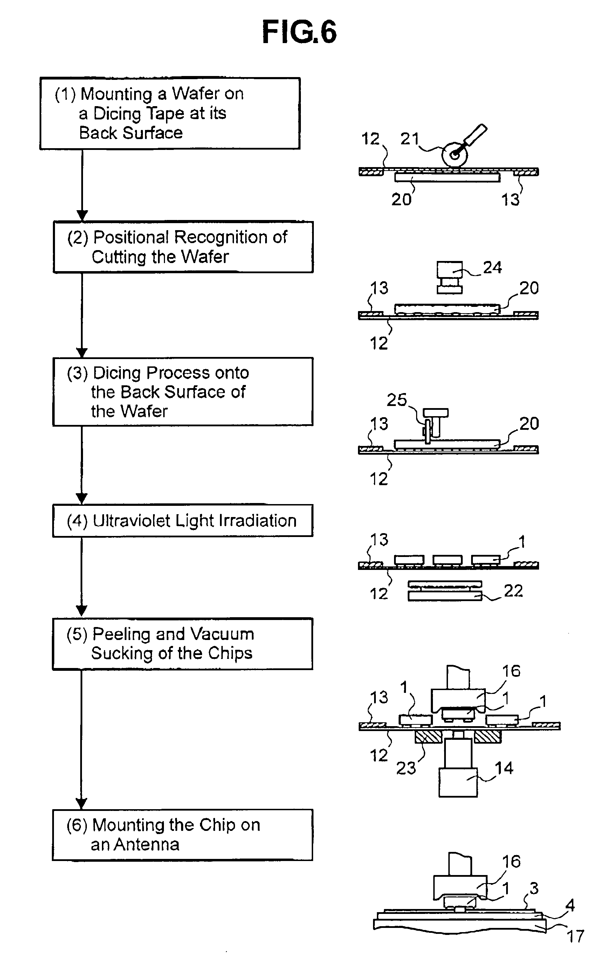

The second embodiment of the present invention will now be described in detail. The present embodiment is different from the first embodiment in terms of a method of mounting an RFID chip 1 on an antenna. In other words, in the first embodiment, the RFID chip 1 is mounted by reversing the RFID chip using the flip chip mounting apparatus. However, in the present embodiment, another structure is adopted. FIG. 6 is a flowchart of a process of mounting the RFID chip according to the present embodiment.

### (1) Mount Semiconductor Wafer on Dicing Tap at its Back Surface

A semiconductor wafer 20 on which a plurality of RFID chips 1 are formed is bonded to a dicing tape 12 supported by a dicing frame 13. Here, the semiconductor wafer 20 is mounted so that a surface (hereinafter referred to as a circuit surface) on which bump electrodes 2 or a circuit is formed is bonded to the dicing tape 12, i.e., a back surface (an opposite surface to the circuit surface) of the semiconductor wafer 20 is not bonded to the dicing tap 12. This is opposite to a general bonding method and called back direction wafer mounting in the present specification. Also, a thickness of an adhesive layer of the dicing tape 12 is required to be thicker than a step difference among the bump electrodes 2 to secure sufficient bonding between the semiconductor wafer 20 and the dicing tape 12. Also, a rubber roller 21 operates to sufficiently bond the semiconductor wafer 20 to the dicing tape 12.

### (2) Recognize Positions of Semiconductor Wafer to be Cut

Before the semiconductor wafer 20 bonded to the dicing tap 12 is diced to be segmented into the RFID chips 1, positions of the semiconductor wafer 20 are recognized. To recognize the positions of the semiconductor wafer 20 to be cut, the circuit surface of the semiconductor wafer 20 must be recognized. However, in the method of the present embodiment, the circuit surface of the semiconductor wafer 20 is bonded to the dicing tap 12. Thus, the circuit surface of the semiconductor wafer 20 may not be observed by a general charge-coupled device (CCD) camera. Thus, in the present embodiment, the circuit surface of the semiconductor wafer 20 is observed from the back surface of the semiconductor wafer 20 using infrared rays and an infrared camera 24. The infrared rays permeate the semiconductor wafer 20 to observe the circuit surface of the semiconductor wafer 20. Also, the positions to be cut may be recognized in a next process.

### (3) Dicing Back Surface of Semiconductor Wafer

A surface on which the circuit of the semiconductor wafer 20 is formed is first notched using a cutting grind stone, e.g., a grinding wheel, in general dicing. However, in the present embodiment, a back surface of the semiconductor wafer 20 is first notched using a cutting grind stone 25. Since the recognition of the positions to be cut has already been completed, a cutting process is performed by a 2-step process like the general dicing.

### (4) Radiate Ultraviolet Light

If the dicing tape 12 is an ultraviolet hardening type, a predetermined amount of ultraviolet light is radiated on the dicing tape 12 using an ultraviolet radiating lamp 22 after back dicing to harden the adhesive layer so as to reduce an adhesive force. Thus, the RFID chip 1 corresponding to a piece of the semiconductor wafer 20 is supplied with the circuit surface (hereinafter referred to as a bump electrode surface) bonded to the dicing tape 12 supported by the dicing frame 13.

### (5) Peel and Vacuum Suck RFID Chips

The RFID chips 1 are peeled off from the dicing tap 12 one by one to be picked up by a chip mounting tool. As a general method of peeling a semiconductor chip from the dicing tape 12, a needle rises passing through the dicing tape 12 to peel the semiconductor chip off from the dicing tape 12. However, in this method, the needle hurts the semiconductor chip. Thus, if the bump electrode surfaces (the circuit surfaces) of the RFID chips 1 are positioned toward the dicing tape 12, functions of the RFID chips are damaged. As a result, the needle may not be adopted. Therefore, the present embodiment uses the chip peeling method disclosed in Japanese Unexamined Patent Publication No. 2003-264203. In other words, when a portion of the dicing tape 12 in the vicinity of the RFID chip 1 to be peeled is supported by a tape supporting plate 23 in a downward direction, a top of an ultrasonically and vertically vibrating pin of a chip peeling mechanism 14 is pushed toward the portion of the dicing tape 12 and thus moves upward and downward to peel the RFID chip 1 from the dicing tape 12. Thus, the RFID chip 1 may be peeled off from the dicing tape 12 without using the needle.

The RFID chip 1 peeled off from the dicing tape 12 is vacuum sucked and continuously adsorbed by the mounting collet 6 standing by above the RFID chip 1.

### (6) Mount RFID Chip

The mounting collet 16 which has adsorbed the RFID chip by vacuum sucking moves to the antenna 3 through a moving member (not shown). The mounting collet 16 arranges potions in which bump electrodes 2 of the RFID chip 1 are to be mounted on the antenna 3 and descends to stop vacuum sucking with applying a load between 100gf and 300gf so as to mount the RFID chip 1 on the antenna 3. Also, before the RFID chip 1 is mounted on the antenna 3, the antenna 3 and the RFID chip 1 are heated at a temperature for softening the binder material of the antenna 3 by the heat source of the base 17 position under the mounting collet 16 and the base member 4. Also, after the RFID chip 1 is mounted on the antenna 3, heating the RFID chip 1 and the antenna 3 stops, and the binder material is re-hardened. The bump electrodes 2 of the RFID chip 1 are bonded to the antenna 3 through the above-described operations.

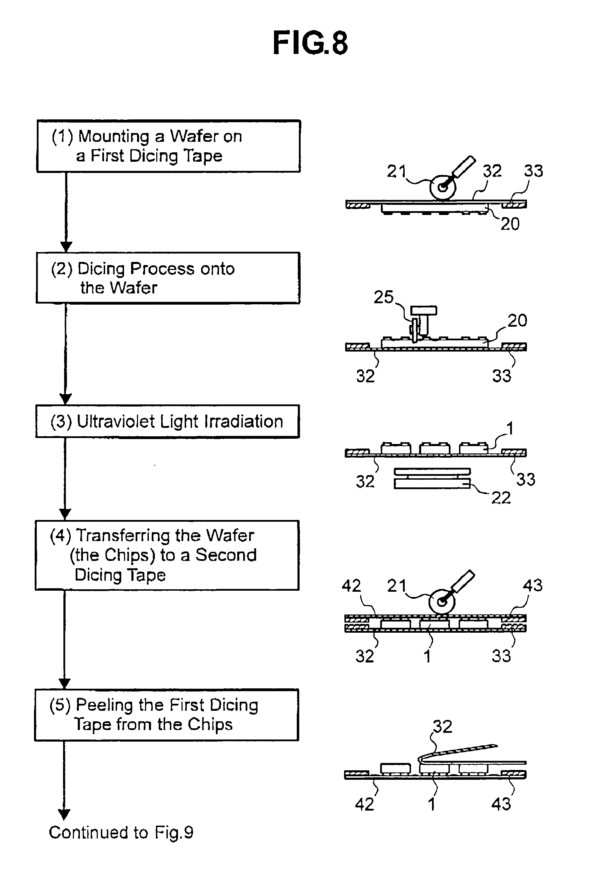

FIG. 7 illustrates a chip mounting apparatus for realizing the above-described mounting process. A structure of the chip mounting apparatus of FIG. 7 is different from the chip mounting apparatus of the first embodiment shown in FIG. 5 in that the chip mount apparatus of the first embodiment includes the reversing arm 11 and the reversible collet 10. The operation of the chip mounting apparatus has been described with reference to FIG. 6.

As in the first embodiment, other operations of supplying an underfill resin, performing laminating, printing additional information, performing cutting, reading ID data, writing information, and performing inspection are performed to complete the RFID tag.

According to the present embodiment, the following effects may be obtained besides the effects of the previous embodiment. In other words, since the RFID chips 1 do not need to be reversed one by one, the structure of the chip mounting apparatus is considerably simplified. Thus, a price of an apparatus for manufacturing RFID tags is considerably reduced, and an investment in equipment for reversing RFID chips one by one can be reduced. Since a low speed chip reversing mechanism is not required, a cycle time (e.g., about 1 second) of the chip mounting apparatus of the present embodiment is more considerably reduced than a cycle time (e.g., about 0.2 second) of the chip mounting apparatus for reversing the RFID chip. The time required for assembling the RFID tag is shortened by a high speed process of mounting the RFID chip on the RFID tag, and productivity of RFID tags is considerably improved. As described above, according to the present embodiment, equipment cost and time for mounting chips are considerably reduce in the mass-production of RFID tags.

### [Third Embodiment]

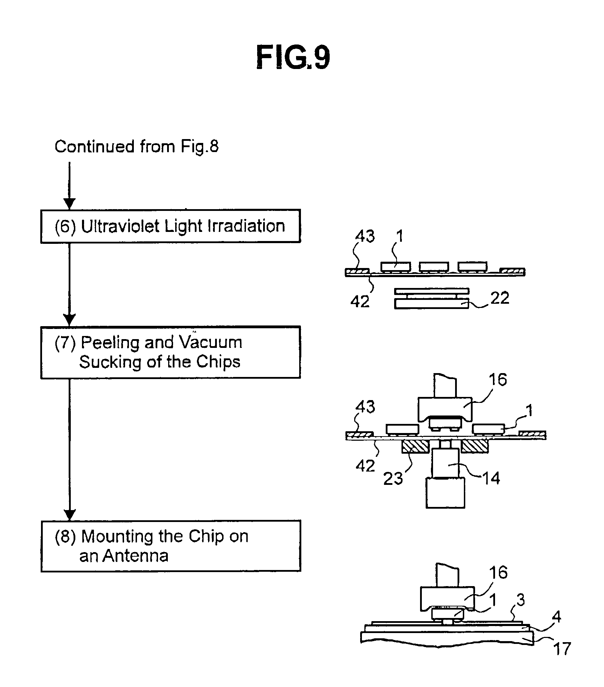

The third embodiment of the present invention will now be described in detail with reference FIGS. 8 and 9 illustrating a flowchart of a process of mounting an RFID chip. The present embodiment is the same as the second embodiment in that the bump electrode surfaces of the RFID chips 1 obtained by dicing the semiconductor wafer 20 are adhered to the dicing tape 12, i.e., the reversed RFID chips 1 are bonded to the dicing tape 12, to be supplied to the chip mounting apparatus. However, the present embodiment is different from the previous embodiments in that the back surface of the semiconductor wafer 20 is bonded to a dicing tape different from the dicing tape 2 to dice the semiconductor wafer 20. In other words, the present embodiment is different from the second embodiment in terms of a method of supplying an RFID chip 1 corresponding to a piece of the semiconductor wafer 20 to a chip mounting apparatus. The method of supplying the RFID chip 1 to the chip mounting apparatus according to the present embodiment will now be described with reference to FIGS. 8 and 9.

### (1) Mount Semiconductor Wafer

The semiconductor wafer 20 on which the plurality of RFID chips 1 are formed is bonded to a first dicing tape 32 supported by a first dicing frame 33. Here, as in a general method, a surface of the semiconductor wafer 20 on which bump electrodes 2 or a circuit are formed does not contact an adhesive surface of the first dicing tape 32, and a back surface of the semiconductor wafer 20 contacts the adhesive surface of the first dicing tape 32.

### (2) Dice Semiconductor Wafer

The semiconductor wafer 20 bonded to the first dicing tape 32 is diced by a cutting grind stone 25 to be segmented into the RFID chips 1. This dicing process is a generally known method.

### (3) Radiate Ultraviolet Light

If the first dicing tape 32 is an ultraviolet hardening type, predetermined ultraviolet rays are irradiated by an ultraviolet radiating lamp 22 after the dicing process to harden the adhesive layer so as to reduce an adhesive force.

### (4) Transfer Semiconductor Wafer

A second dicing frame 43 and a second dicing tape 42 bonded to the second dicing frame 43 are provided, and an adhesive surface of the second dicing tape 42 contacts the plurality of RFID chips 1 bonded to the first dicing tape 32 using a rubber roller 21.

### (5) Peel First Dicing Tape

The first dicing frame 33 is separated from the first dicing tape 32 and then removed. The first dicing tape 32 is peeled off from the RFID chips 1 at an acute angle.

Thus, the plurality of RFID chips 1 are transferred from the first dicing tape 32 to the second dicing tape 42. The RFID chips 1 are reversed, and bump electrode surfaces or circuit surfaces of the RFID chips 1 are adhered on the adhesive surface of the second dicing tape 42.

### (6) Radiate Ultraviolet Light

If the second dicing tape 42 is an ultraviolet hardening type, predetermined ultraviolet rays are radiated by the ultraviolet radiating lamp 22 to harden the adhesive layer so as to reduce an adhesive force.

The RFID chip 1 corresponding to a piece of the semiconductor wafer 20 is supplied with the circuit surfaces or the bump electrodes adhered to the second dicing tape 42 supported by the second dicing frame 43. The remaining operations are the same as those of FIG. 6 after operation (5) and will be described below.

### (7) Peel and Vacuum Suck RFID Chips

The RFID chips 1 are peeled off from the second dicing tape 42 one by one to be picked up by the mounting collet 16. As described in the second embodiment, when the portion of the RFID chip to be peeled off from the second dicing tape 42 is supported downward by the tape supporting plate 23, the top of the ultrasonically and vertically vibrating pin of the chip peeling mechanism 14 is pushed to the portion of the second dicing tape 42, and the RFID chips 1 are peeled off from the second dicing tape 42 due to repeated up and down movements of the portion. The peeled RFID chips 1 are vacuum sucked and adsorbed by the mounting collet 16 standing by above the RFID chips 1.

### (8) Mount RFID Chips

The mounting collet 16 which has adsorbed the RFID chips by vacuum sucking moves onto the antenna 3 by the moving member (not shown). The mounting collet arranges positions in which the bump electrodes 2 of the RFID chips 1 are to be mounted on the antenna 3 are arranged and descends to stop vacuum sucking with applying a load between 100gf and 300gf so as to mount the RFID chips 1 on the antenna 3. Also, before the RFID chips 1 are mounted on the antenna 3, the antenna 3 and the RFID chips 1 are heated at the temperature for softening the binder material of the antenna 3 by the heat source of the base 17 positioned under the mounting collet 16 and the base member 4. Also, after the RFID chips 1 are mounted on the antenna 3, heating the RFID chips 1 and the antenna 3 stops, and the binder material is re-hardened. The bump electrodes 2 of the RFID chips 1 are bonded to the antenna 3 through the above-described operations.

According to the present embodiment, a dicing process using a conventional dicing apparatus not including an infrared camera may be performed besides the effects of the first and second embodiments. Thus, manufacturing cost may be reduced as in the second embodiment.

### [Fourth Embodiment]

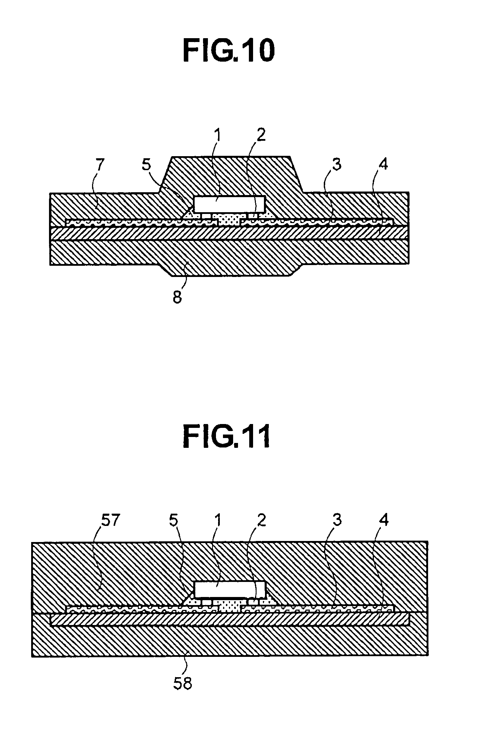

The fourth embodiment of the present invention will be described with reference to FIG. 10. FIG. 10 is a cross-sectional view of an RFID tag according to the present embodiment. The structure of the RFID tag is obtained by modifying the structure of the RFID tag of the first embodiment. In other words, the surface sheet 6 of the first embodiment is changed into a front protection sheet 7. A back protection sheet 8 that is not shown in the first embodiment is added in the present embodiment. In other words, a structure of the base member 4, the antenna 3 formed on the base member 4, the RFID chips 1 having the bump electrodes 2 mounted on the antenna 3, and the insulating resin 5 covering the bonding part between the RFID chips 1 and the antenna 3 is laminated so that a surface of the corresponding structure (an upper part shown in FIG. 10) is inserted into the front protection sheet 7 and a back surface of the structure is inserted into the back protection sheet 8 to be laminated. The front and back protection sheets 7 and 8 are resin sheets representative as polyesters, and portions of the front and back protection sheets 7 and 8 are processed to be bulky in their thicknesses. In other words, a portion of a resin sheet having a thickness of 0.1mm is processed to a bulky thickness of about 0.5mm. When the bulky (thicker) portions of the front and back protection sheets 7 and 8 are arranged in positions of the RFID chips 1, the RFID tag of the present embodiment is laminated.

According to the present embodiment, the bonding part between the RFID chips 1 and the antenna 3 is strongly protected by the bulky portions of the front and back protection sheets 7 and 8. Thus, RFID tags highly durable with respect to mechanical external forces may be obtained. In other words, the bonding part between the RFID chips 1 and the antenna 3 is protected by laminating sheets (the front and back protection sheets 7 and 8) besides the thermoplastic insulating resin 5. Strengths of the laminating sheets are improved in their thicker portions. Also, the thicker portions of the laminating sheets cover a portion around the bonding part between the RFID chips 1 and the antenna 3. Thus, a portion around the bonding part of the RFID chips 1 of the RFID tag becomes bulky, and the durability of the RFID tag with respect to a mechanical load such as bending or twisting. As a result, the stable bonding part between the bump electrodes 2 of the RFID chips 1 and the antenna 3 is maintained.

### [Fifth Embodiment]

The fifth embodiment of the present invention will now be described with reference to FIG. 11. FIG. 11 is a cross-sectional view of an RFID tag according to the present embodiment. The structure of the RFID tag is obtained by modifying a portion of the structure of the RFID tag of the first embodiment. In other words, the surface sheet 6 of the first embodiment is changed into a front silicon layer 57. Also, a back silicon layer 58 that is not shown in the first embodiment is added in the present embodiment. In other words, in a structure of the base member 4, the antenna 3 formed on the base member 4, the RFID chips 1 having the bump electrodes 2 mounted on the antenna 3, and the insulating resin 5 covering the bonding part between the RFID chips 1 and the antenna 3, a surface (an upper part shown in FIG. 11) of the structure is inserted into the front silicon layer 57, and a back surface (a lower part shown in FIG. 11) of the structure is inserted into the back silicon layer 58. The front and back silicon layers 57 and 58 are formed of a silicon rubber having a thickness of 2mm or more. The silicon rubber is soft but thick. Thus, although the RFID tag of the present embodiment is bent, a curvature diameter of the bending portion is very greater than when the front and back silicon layers 57 and 58 do not exist, and wrinkles do not contact the antenna 3. Thus, a mechanical load on the antenna 3 is considerably relieved. As a result, RFID tags highly durable with respect to mechanical external forces may be obtained.

In the present embodiment, an outer edge of the RFID tag is sealed by a silicon resin, and thus the durability of the RFID tag with respect to the mechanical load such as bending or twisting is improved.

As described above, according to the present invention, the reliability of an RFID tag can be improved, and a price of the RFID tag can be lowered. Also, the RFID tag can be applied in fields in which RFID tags cannot be applied in terms of cost and reliability. Thus, many users can enjoy advantages of introducing the RFID tags.

While we have shown and described several embodiments in accordance with the present invention, it is understood that the same is not limited thereto but is susceptible of numerous changes and modifications as known to those skilled in the art, and we therefore do not wish to be limited to the details shown and described herein but intend to cover all such changes and modifications as are encompassed by the scope of the appended claims, as interpreted by the description and drawings.

## Claims

1. An RFID tag comprising an RFID IC chip and an antenna,
wherein the RFID IC chip comprising bump electrodes,
the antenna is formed of a conductive paste comprising conductive particles on one of a resin material and a paper material, the bump electrodes of the RFID IC chip are connected to the antenna by a thermoplastic resin contained in the conductive paste of the antenna, and a lower surface of the RFID IC chip and an upper surface of the antenna are covered with the thermoplastic resin.

2. The RFID tag of claim 1, wherein the conductive paste is a silver paste containing silver flakes and a thermoplastic polyester resin as a binder material.

3. The RFID tag of claim 1, wherein the conductive paste is a silver paste containing silver flakes and a thermoplastic polyolefin resin as a binder material.

4. The RFID tag of claim 1, wherein a surface of the RFID tag is laminated.

5. The RFID tag of claim 1, wherein a surface and a back surface of the RFID tag are laminated with a sheet material having a portion locally thick, and the portion of the sheet material is arranged with the RFID IC chip.

6. The RFID tag of claim 1, wherein a surface and a back surface of the RFID tag are covered with a silicone rubber.

7. An RFID tag comprising:
a base member;
an antenna layer formed of a resin material containing conductive particles on a main surface of the base member; and
an TC chip having a surface on which electrodes are formed and which faces a portion of the main surface of the base member to connect the electrodes to the antenna,
wherein the antenna has a first portion facing the surface of the IC chip and a second portion extending outside a region of the main surface of the base member covered with the IC chip,
the electrodes of the IC chip are bonded to the first portion of the antenna by the resin material of the antenna, and
a density of a solvent or a precursor of the resin material remaining the first portion of the antenna is lower than that remaining in the second portion.

8. The RFID tag of claim 7, wherein an insulating resin is formed between the portion of the main surface of the base member and the surface of the IC chip to seal a connection between the first portion of the antenna and the electrodes of the IC chip, and
the insulating resin is a thermoplastic resin having a higher glass transition temperature than that of the resin material.

9. The RFID tag of claim 8, wherein the resin material is softened from its cure state when the resin material is heated at a predetermined temperature in a range not less than 50°C and less than 150°C.*

10. The RFID tag of claim 7, wherein the electrodes of the IC chip is in contact with the first portion of the antenna only via bottom surfaces thereof opposed to the main surface of the base member, and
the antenna is not in contact with any one of sides of the electrodes adjacent the bottom surfaces thereof.

11. The RFID tag of claim 10, wherein a region of the first portion of the antenna in contact with the bottom surfaces of the electrodes is thinner than the second portion of the antenna.

12. The RFID tag of claim 7, wherein the electrodes of the IC chip is in contact with the first portion of the antenna only via bottom surfaces thereof opposed to the main surface of the base member and at least portions of sides thereof adjacent to the bottom surfaces thereof, and
a region of the first portion of the antenna in contact with the bottom surfaces of the electrodes is not thinner than the second portion of the antenna.

13. A method of manufacturing an RFID tag, comprising steps of:
printing a conductive paste containing a thermoplastic resin and conductive particles on a resin material or a paper material to form an antenna;
arranging bump electrodes of an IC chip for the RFID tag in positions of the antenna in which the bump electrodes of the IC chip are to be mounted;
pressing the IC chip and the antenna by heat;
supplying a thermoplastic resin to a bonding part between the IC chip and the antenna; and
hardening the thermoplastic resin by heat.

14. A method of manufacturing an RFID tag, comprising:
bonding bump electrode surfaces of a semiconductor wafer on which a plurality of IC chips are sequentially formed to an adhesive tape;
dicing a surface of the semiconductor wafer opposite to the bump electrode surfaces to segment the semiconductor wafer into the IC chips; and
peeling the IC chips from an adhesive tape without reversing the IC chips and mounting each of the IC chips on the antenna without reversing the each of the IC chips to connect the each of the IC chips to the antenna.

15. A method of manufacturing an RFID tag, comprising:
bonding a surface of a semiconductor wafer opposite to bump electrode surfaces of the semiconductor wafer on which a plurality of IC chips are sequentially formed to a first adhesive tape;
dicing the semiconductor wafer to segment the semiconductor wafer into the IC chips;
transferring the IC chips to a second adhesive tape so that the bump electrode surfaces are adhered to the second adhesive tape;
peeling the IC chips off from the first and second adhesive tapes without reversing the IC chips; and
mounting each of the IC chips on the antenna without reversing the each of the IC chips to connect the each of the IC chips to the antenna.
